(19) **Europäisches Patentamt / European Patent Office / Office européen des brevets**

(11) **EP 1 641 092 B1**

(12) **EUROPEAN PATENT SPECIFICATION**

(45) Date of publication and mention
of the grant of the patent:
**22.02.2012 Bulletin 2012/08**

(51) Int Cl.:
***H01S 5/183*** (2006.01)   ***H01S 5/36*** (2006.01)
***H01L 51/50*** (2006.01)   ***H01L 51/52*** (2006.01)

(21) Application number: **04746279.1**

(22) Date of filing: **23.06.2004**

(86) International application number:
**PCT/JP2004/008810**

(87) International publication number:
**WO 2005/002010 (06.01.2005 Gazette 2005/01)**

(54) **ORGANIC LASER DEVICE**

ORGANISCHES LASERBAUELEMENT

DISPOSITIF LASER ORGANIQUE

(84) Designated Contracting States:
**DE FI FR GB NL**

(30) Priority: **27.06.2003  JP 2003185850**

(43) Date of publication of application:
**29.03.2006 Bulletin 2006/13**

(73) Proprietor: **Semiconductor Energy Laboratory
Co., Ltd.
Atsugi-shi, Kanagawa-ken 243-0036 (JP)**

(72) Inventors:
 • **NOMURA, Ryoji
  Atsugi-shi, Kanagawa 2430036 (JP)**
 • **ABE, Hiroko
  Atsugi-shi, Kanagawa 2430036 (JP)**

 • **YUKAWA, Mikio
  Atsugi-shi, Kanagawa 2430036 (JP)**

(74) Representative: **Grünecker, Kinkeldey,
Stockmair & Schwanhäusser
Anwaltssozietät
Leopoldstrasse 4
80802 München (DE)**

(56) References cited:
EP-A- 1 154 676     EP-A1- 0 878 883
WO-A-00/36664      WO-A1-01/39554
DE-A1- 10 162 783   JP-A- 5 343 183
JP-A- 2000 058 259  JP-A- 2003 168 567
US-A- 5 478 658     US-A- 5 907 160
US-A- 6 160 828     US-A1- 2002 009 274
US-A1- 2002 158 263  US-A1- 2003 103 537
US-B1- 6 262 441

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

The present invention relates to a laser apparatus employing an organic material, more particularly to a current excitation type organic laser apparatus.

BACKGROUND ART

A solid-state laser has characteristics such as high power output, high efficiency, large energy accumulation, wide wavelength variation, and small size, thus the laser can be applied in a wide field. In particular, a semiconductor laser has major characteristics such as small size, light weight and low threshold value. A semiconductor laser using an inorganic semiconductor has been already developed and put into practical use in many fields.

On the other hand, the realization of laser oscillation by employing an organic compound can give a laser the characteristics that cannot be obtained in an inorganic semiconductor laser. For example, a flexible laser can be manufactured because of the flexibility of material, the simple manufacturing process and the cost reduction can be realized, and various manufacturing processes can be employed (deposition, spin coating method, printing method, dip coating method, or the like can be adopted). Non-Patent Document 1 describes a laser employing an organic compound as a summary.

Many examples of laser oscillation by the light excitation of an organic compound have been disclosed already. Laser oscillation can be relatively easily realized by irradiating by using a laser for the light excitation, for example, a nitrogen laser, employing a fluorescence material that has a high quantum yield. However, extremely large energy is required for the laser oscillation and the energy density in the range of several $\mu J/cm^2$ to several hundreds $\mu J/cm^2$ is to be required. This value corresponds to the energy density in the range of several dozens $W/cm^2$ to several thousands $W/cm^2$, that is, it is required to flow current of approximately in the range of 10 A to 1000 A with voltage of several dozens in the case of an element of one centimeter square.

As a typical light emitting element in which an organic material emits light, an organic electroluminescence (EL) element is known. This element is structured such that layers each referred to as a hole transporting layer, a light emitting layer and an electron transporting layer are laminated between a pair of electrodes by employing an organic material. In order to emit light, voltage is applied between the both electrodes to inject an electron and a hole into the light emitting layer. This light emission has a relatively wide wavelength band (color purity is low) and has no directivity, though its wavelength band can be varied depending on kinds of material employed for a light emitting layer or of guest material doped to the light emitting layer. Therefore, this light emission cannot function as laser light. Furthermore, a conventional organic EL element does not allow high density current to flow which is required for the laser oscillation.

Non-Patent Document 1: Nir Tessler, "Lasers Based on Semiconducting Organic Materials", Adv. Mater., 1999, 11, p. 363-370

WO 00/36664 relates to an edge-emitting type light emitting device comprising an organic light emitting layer, a pair of electrode layers and an optical waveguide which transmits light emitted from the organic light-emitting layer to the edge. The optical waveguide comprises a core layer into which a granting is incorporated and a cladding layer.

EP 1 154 676 relates to a display device having a first electrode of light reflective material, an organic layer including an organic light emitting layer, semi-transparent reflection layer and a second electrode of a transparent material that are stacked sequentially and so configured that the organic layer functions as a cavity portion such that light resonates in a certain spectral width.

EP-A-0878883 relates to an organic laser which comprises an electrically pumped source of incoherent radiation with an organic active region, and further comprises a waveguide structure that receives the incoherent radiation. The core of the waveguide comprises organic material that absorbs the incoherent radiation and emits coherent radiation of longer wavelength.

DISCLOSURE OF THE INVENTION

PROBLEM TO BE SOLVED BY THE INVENTOR

The invention is made in view of the above-mentioned problems, and an object of the invention is to provide a laser apparatus in which an organic material is employed as a laser medium and current excitation can occur.

MEANS FOR SOLVING THE PROBLEM

The invention relates to an organic laser apparatus including an organic compound that radiates laser light when current is injected as defined in claim 1. Preferred embodiments are defined in the dependent claims. Thin films mainly made of an organic compound and formed between a pair of electrodes are collectively referred to as an organic compound layer in the invention. In the organic compound layer employed for the laser apparatus of the invention, a laminated structure and film thickness of each layer are determined in consideration of wavelength so as to radiate laser light. The organic compound layer is formed so as to be sandwiched between a pair of electrodes and, preferably, formed by a plurality of layers each has a different carrier transport property and a different light emission wavelength. In addition, it is a preferable mode to form to be a so-called resonator structure, in which a reflector is provided between a pair of electrodes.

In an organic laser apparatus of the invention, a plurality of layers capable of emitting light are formed in contact each other in an organic compound layer so that laser light can be radiated by flowing current into the organic compound layer formed between a pair of electrodes.

It is preferable that the organic laser apparatus has a so-called resonator structure in which a reflector is provided to either or both sides of an organic compound layer between a pair of electrodes. That is, it is a preferable mode to provide a reflector to at least one of the sides of the organic compound layer between the pair of electrodes so that a standing wave is produced with respect to light of a specified wavelength emitted in the organic compound layer. In addition, the organic compound layer is preferably formed to have a thickness of 1/2 time (half wavelength) as a wavelength of laser light or integral multiple of the same. Note that, it is known that a light speed in a substance is different from that in a vacuum and the light speed in a substance is obtained by multiplying the light speed in a vacuum by a refractive index of the substance. In practice, therefore, a film thickness obtained by deviding a film thickness in an organic compound by a refractive index (defined as an optical film thickness, hereinafter. That is, an optical film thickness = film thickness x refractive index.) is required to be of integral multiple of the half wavelength of the laser light. Hereinafter, a film thickness means merely a film thickness of a substance, while an optical film thickness means that obtained by multiplying the film thickness of a substance by its refractive index.

The invention relates to an organic laser apparatus, in which an organic compound layer that radiates light having a plurality of emission peaks and at least one emission peak with a half-band width of 10 nm or less is provided between a pair of electrodes.

An organic compound layer applied in the invention is structured by combining a hole injecting layer, a hole transporting layer, a light emitting layer, an electron transporting layer, an electron injecting layer, and the like with each other arbitrarily. For this classification, a layer superior in a hole transport property such as hole mobility is referred to as a hole injecting layer or a hole transporting layer, while a layer superior in an electron transport property such as electron mobility is referred to as an electron transporting layer or an electron injecting layer. Though the hole injecting layer and the hole transporting layer are described respectively, they are the same in terms that they have the common property of hole transportation as an important property. For convenience, a layer bounded on an anode is referred to as a hole injecting layer, and a layer bounded on a light emitting layer is referred to as a hole transporting layer. Further, a layer bounded on a cathode is referred to as an electron injecting layer, and a layer bounded on a light emitting layer is referred to as an electron transporting layer. The light emitting layer may function as the electron transporting layer, and thus it can be referred to as a light emitting electron transporting layer as well. In addition, the light emitting layer may also function as a hole injecting layer, a hole transporting layer, an electron injecting layer, and the like. Further, the light emitting layer can be formed by a metal complex, an organic dye material, various derivatives, or the like in order to vary emission color.

In the case of applying such a laminated structure of an organic compound layer, electrons injected from a cathode and holes injected from an anode are recombined in the light emitting layer to form an exciton, and the exciton radiates light when it returns to the ground state. Light emission is obtained by so-called electroluminescence. According to the invention, laser light can be induced by forming a hole transporting layer bounded on a light emitting layer so as to radiate light having a peak with a half-band width of 10 nm or less in a shorter wavelength side than a wavelength band of light that is emitted in the light emitting layer by injecting current.

The invention relates to an organic laser apparatus in which an organic compound layer that radiates light having a peak with a half-band width of 10 nm or less by injecting current is provided between a pair of electrodes, and the variation of emission intensity at the emission peak with respect to current density can be sorted by two linear regions with different slopes. A region of a sharp slope is at higher current density side compared to a region of a slow slope. In particular, according to the invention, a current density at which two linear regions with different slopes are in contact with each other (described as a threshold value, hereinafter) is in the range of 5 mA/cm$^2$ to 20 mA/cm$^2$. In addition, the half-band width of an emission peak is varied by 20 % or more until current density for injecting into an organic compound layer is reached to a threshold value.

According to the above-mentioned structure of the invention, a laser apparatus can be obtained in which an organic material is employed as a laser medium and current excitation can occur.

As a substance for forming the first layer of an organic compound layer, that having hole mobility of 10$^{-6}$ cm$^2$/V · sec or more is preferable such as 4,4'-bis [N-(1-naphthyl)-N-phenyl-amino] biphenyl (described as α-NPB, hereinafter), 4,4',4"-tris (N,N-diphenylamino) triphenylamine (described as TDATA, hereinafter), 4,4'-bis [N-(3-methylphenyl)-N-phenylamino] biphenyl (described as TPD, hereinafter), and 4,4',4"-tris (N-carbazolyl) triphenylamine (described as TCTA, hereinafter). Note that, other substances than those cited here may be employed.

As a substance for forming the second layer, that having electron mobility of $10^{-8}$ $cm^2/V \cdot sec$ or more is preferable such as a metal complex having a quinoline skeleton or a benzoquinoline skeleton typified by tris (8-quinolinolate) aluminum (described as $Alq_3$, hereinafter) and a mixed ligand complex thereof. Alternatively, other than the metal complexes, an oxadiazole derivative such as 2-(4-biphenyl)-5-(4-tert-butylphenyl)-1,3,4-oxadiazole (described as PBD, hereinafter) and 1,3-bis [5-(p-tert-butylphenyl)-1,3,4-oxadiazole-2-yl] benzene (described as OXD-7, hereinafter), a triazole derivative such as 3-(4-tert-butylphenyl)-4-phenyl-5-(4-biphenylyl)-1,2,4-triazole (described as TAZ, hereinafter) and 3-(4-tert-butylphenyl)-4-(4-ethylphenyl)-5-(4-biphenylyl)-1,2,4-triazole (described as p-EtTAZ, hereinafter), a phenanthroline derivative such as bathophenanthroline (described as Bphen, hereinafter) and bathocuproin (described as BCP, hereinafter), or 4,4'-(N-carbazolyl) biphenyl (described as CBP, hereinafter) can be employed. Note that, other substances than those cited here may be employed.

Note that, one or both of the first layer and the second layer may include an inorganic compound.

Effect of the Invention

According to the invention, laser oscillation can be preformed by current excitation by using an organic material as a laser medium. That is, an organic laser apparatus in which current excitation can occur can be obtained.

BRIEF DESCRIPTION OF DRAWINGS

[FIG 1] FIG 1 is a cross-sectional view explaining a structure of a laser apparatus described in example 1.
[FIG 2] FIG 2 is a cross-sectional view explaining a structure of a laser apparatus described in example 2.
[FIG 3] FIG 3 is a cross-sectional view explaining a structure of a laser apparatus described in example 3.
[FIG 4] FIG 4 is a cross-sectional view explaining a structure of a laser apparatus described in example 4.
[FIG 5] FIG 5 is a cross-sectional view explaining a structure of a laser apparatus described in example 5.
[FIG 6] FIG 6 is a cross-sectional view explaining a structure of a laser apparatus described in an Embodiment Mode.
[FIG. 7] FIG. 7 is a graph showing a light emission property of an element manufactured in example 1 and results of emission spectra measured by a detector at various angles.
[FIG 8] FIG 8 is a view explaining a structure of an element manufactured in Embodiment 1.
[FIG 9] FIG. 9 is a graph showing emission spectra of an element manufactured in Embodiment 1.
[FIG 10] FIG 10 shows graphs showing (A) a voltage to current characteristic and (B) a voltage to emission intensity characteristic of an element manufactured in example 1.
[FIG .11] FIG 11 shows graphs showing current density dependence of emission spectra of an element manufactured in example 1, which are standardized at the highest emission intensity.
[FIG. 12] FIG 12 is a graph showing emission spectra at a current density of 120 mA/$cm^2$ of an element manufactured in example 1.
[FIG 13] FIG 13 shows graphs showing a light emission property of an element manufactured in example 1, in which a half-band width of an emission peak of 460 nm is plotted against current density.
[FIG 14] FIG 14 is a view explaining a structure of a light emitting element described in example 6.
[FIG. 15] FIG 15 is a view explaining a structure of a light emitting element manufactured in example 2.
[FIG 16] FIG. 16 shows graphs explaining structures of a light emitting element manufactured in example 2 and a light emitting element of a comparative example.
[FIG. 17] FIG 17 is a graph showing current density dependence of emission intensity of a light emitting element manufactured in Embodiment 2 and of a light emitting element of a comparative example.
[FIG. 18] FIG 18 is a view explaining a laminated structure of a light emitting element of a comparative example.

BEST MODE FOR CARRYING OUT THE INVENTION

The inventors consider that the study of light excitation organic laser which has been reported so far has a problem in measuring method of a threshold value. In an organic solid-state laser by the light excitation, conventionally, fluorescence light obtained by irradiating strong laser light to a thin film of organic compound has been measured. A fluorescence spectrum is measured while varying incident energy of the laser light, and an emission peak intensity with a narrow half-band width is monitored. It is the problem in measurement that all of the incident energy is assumed to be absorbed by the organic compound in a film. In practice, laser light which transmitted instead of being absorbed by the organic compound in the thin film and laser light reflected by the film are not taken into consideration. Therefore, energy density required for the laser oscillation is supposed to be quite lower than the reported one.

In an organic EL element, a large number of carriers are supplied to a thin film of organic compound. When applying current, the number of carriers presented in the organic EL element and the number of molecules in the element become approximately equivalent, or the number of carriers becomes larger than that of molecules. Therefore, the number of molecules with no carriers, that is, the number of molecules in a ground state, may be smaller than that of molecules with carriers. When an excitation state is produced due to carrier recombination in this state, it is possible to create the state that the number of molecules in the excitation state is relatively larger than that of molecules in a ground state. Hence, it can be expected that population inversion can be sufficiently produced by applying a small amount of current. It is preferable to provide a resonator structure with the element. That is, when an optical film thickness of a thin film of organic compound functioning as a resonator is formed to be of integral multiple of a half wavelength, it can be expected that laser oscillation can be realized by light amplification due to the induced radiation and resonation generated in the state of population inversion.

The inventors, therefore, examined in detail the correlation between current density and emission intensity in the low current region in order to explore the possibility of the laser oscillation from an organic EL element. As a result, it is found that whole or a part of the correlation between current density and emission intensity shows two straight lines with different slopes, and a region of a sharp slope is at a higher current density side compared to a region of a slow slope. Then, it is found that a current density (a threshold value) at which the two regions are in contact with each other takes quite a small value in the range of several mA/cm$^2$ to several dozens mA/cm$^2$. At the same time, it is clarified that the half-band width of emission spectrum is decreased by approximately 20 % in the vicinity of the threshold value. That is, it can be confirmed that even a current excitation type laser apparatus employing an organic compound as a medium shows the same behavior as a so-called solid-state laser by forming a certain plurality of layers of organic compound in contact.

example 1

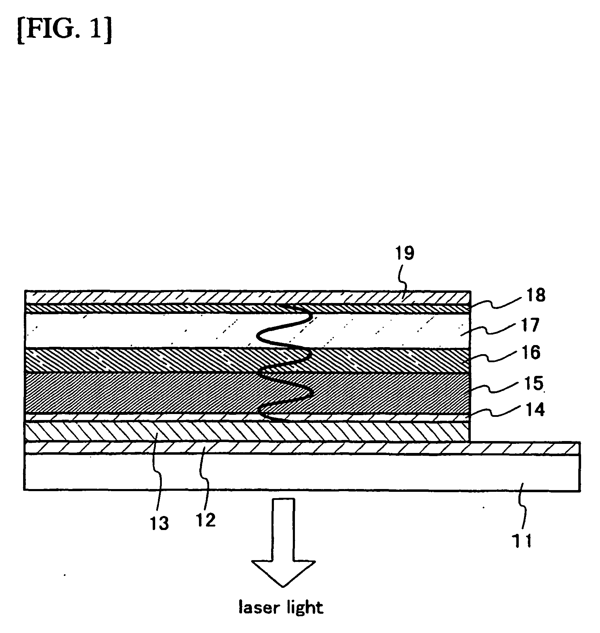

Described in this example is a structure in which laser light can be extracted from a substrate side (an anode side) in a laser apparatus in which an electrode and an organic compound layer are laminated on the substrate. FIG. 1 shows a laser apparatus of this example structured by laminating a plurality of layers on a substrate 11. In this example, since laser light is extracted from the substrate side 11, a substrate which transmits laser light may be used. Specifically, glass, quartz, transparent plastic, or the like can be employed. Reference numeral 12 denotes an anode to which metal, alloy, electrical conductive compound, or mixture thereof can be employed and a work function is not exclusively required to be taken into consideration. The reason is that a conductive reflector 13 formed on the anode 12 injects a hole into the organic compound layer, thus the anode 12 is required only to form an ohmic contact with the conductive reflector 13. However, since laser light is outputted toward the substrate side 11 in this structure, it is preferable that the anode 12 transmits light as much as possible. Therefore, in the case of employing metal or alloy as a material for the anode 12, metal having small absorption property in the visible light region is preferably employed as a thin film to form the anode 12. Specifically, translucent conductive oxide such as ITO (Indium Tin Oxide) and ZnO (Zinc Oxide), or translucent conductive nitride such as TiN (Titanium Nitride) can be employed. However, since these materials absorb light to some extent, the anode 12 is preferably to be a thin film in a film thickness of approximately 100 nm or less.

The conductive reflector 13 functions as an electrode for injecting a hole into the organic compound layer and, in addition, as a reflecting mirror for forming a standing wave by keeping light occurred in a light emitting layer 16. Accordingly, such a material having small visible light absorption property, high reflectance, and conductivity is preferably employed for the conductive reflector 13 as a reflecting mirror. For the hole injection into the organic compound layer, it is necessary to choose a material with a high work function (a work function of 4.0 eV or more). Ag, Pt, or the like are examples that satisfy the aforementioned requirements. The conductive reflector 13 functioning as a reflecting mirror has preferably the reflectance of approximately 50 % to 95 % in order to extract laser light therethrough.

The organic compound layer includes a hole injecting layer 14 having a high hole injection property from the anode; a hole transporting layer 15 for efficiently transporting holes from the hole injecting layer 14 to the light emitting layer 16; an electron injecting layer 18 having a function of reducing an electron injection barrier from a cathode 19; and an electron transporting layer 17 for efficiently transporting injected electrons to the light emitting layer 16. The injected carriers (holes and electrons) are recombined in the light emitting layer 16. An emission mechanism in which carriers are injected, transported, and recombined is similar to the general organic EL element. Therefore, materials that can be employed for the general organic EL element can be employed for the aforementioned each functional layer. Note that, though five functional layers are used as an organic compound layer in this embodiment mode, the invention is not limited to this and the number of layers can be reduced by forming one layer to have a plurality of functions.

As a hole injection material for forming the hole injecting layer 14, a material having small ionization potential is employed, which is roughly classified into metal oxide, low molecular weight organic compound, and high molecular weight compound. The metal oxide such as vanadium oxide, molybdenum oxide, ruthenium oxide, and aluminum oxide can be used. The low molecular weight organic compound includes starburst type amine typified by m-MTDATA, metallophthalocyanine and the like. The high molecular weight compound such as conjugated polymer such as polyaniline and polythiophene derivative can be used. By employing the above-mentioned materials for the hole injecting layer 14, a hole injection barrier is reduced to inject holes effectively.

For the hole transporting layer 15, known materials such as aromatic amine can be preferably employed. For example, 4,4'-bis [N-(1-naphthyl)-N-phenyl-amino] biphenyl (described as $\alpha$-NPB, hereinafter), 4,4',4"-tris (N,N-diphenyl-amino) triphenyl amine (described as TDATA, hereinafter), or the like can be employed. As a high molecular weight material, poly (vinyl carbazole) which has an excellent hole transportation property, or the like may be used alternatively.

For the light-emitting layer 16, known materials can be employed. For example, a metal complex such as tris (8-quinolinolate) aluminum (described as $Alq_3$, hereinafter), tris (4-methyl-8-quinolinolate) aluminum (described as Almq, hereinafter), bis (10-hydroxybenzo[$\eta$]-quinolinote) beryllium (described as $BeBq_2$, hereinafter), bis (2-methyl-8-quinolinolate)-(4-hydroxy-biphenylyl)-aluminum (described as BAlq, hereinafter), bis [2-(2-hydroxyphenyl)-benzooxazolate] zinc (described as $Zn(BOX)_2$, hereinafter), bis [2-(2-hydroxyphenyl)-benzothiazolate] zinc (described as $Zn(BTZ)_2$, hereinafter), and various types of fluorescent dye can be employed. Further, phosphorescent materials such as platinum octaethylporphyrin complex, tris (phenylpyridine) iridium complex, and tris (benzylidene-acetonato) phenanthrene europium complex can be efficiently employed. In particular, a phosphorescent material has longer excitation lifetime than a fluorescent material, thus population inversion, that is, the state in which the number of molecules in an excited state is larger than that in a ground state can be generated easily, which is essential to laser oscillation.

Note that, a light emitting material may be used as a dopant in the above-mentioned light emitting layer. That is, a material having larger ionization potential and band gap than those of the light emitting material may be used as a host material, and a small amount of the above-mentioned light emitting material (approximately from 0.001 % to 30 %) may be mixed into the host material.

For the electron transporting layer 17, known materials can be employed. Specifically, a metal complex having a quinoline skeleton or a benzoquinoline skeleton typified by $Alq_3$, or a mixed ligand complex thereof is preferable. Alternatively, other than the metal complex, an oxadiazole derivative such as 2-(4-biphenylyl)-5-(4-tert-butylphenyl)-1,3,4-oxadiazole (described as PBD, hereinafter), 1,3-bis [5-(p-tert-butylphenyl)-1,3,4-oxadiazole-2-yl] benzene (described as OXD-7, hereinafter), a triazole derivative such as 3-(4-tert-butylphenyl)-4-phenyl-5-(4-biphenylyl)-1,2,4-triazole (described as TAZ, hereinafter), and 3-(4-tert-butylphenyl)-4-(4-ethylphenyl)-5-(4-biphenylyl)-1,2,4-triazole (described as p-EtTAZ, hereinafter), and a phenanthroline derivative such as bathophenanthroline (described as BPhen, hereinafter) and bathocuproin (described as BCP, hereinafter) can be used.

For the electron injecting layer 18, an alkali metal salt such as lithium fluoride and cesium bromide, and an alkaline earth metal salt such as calcium fluoride can be used. The cathode 19 is formed on the electron injecting layer 18. The cathode 19 may be formed by metal, alloy, electrical conductive compound, and mixture thereof having a small work function, each of which is employed for the general EL element. Specifically, a representative element of group 1 or 2 in the periodic table, that is, an alkali metal such as Li and Cs; an alkali earth metal such as Mg, Ca, and Sr; an alloy containing the foregoing materials (Mg/Ag, Al/Li); or a transition metal containing a rare earth metal can be used. Alternatively, the cathode 19 may be formed by stacking a metal such as Al, Ag, and ITO (including an alloy) with the foregoing materials. A resonator structure is required between the cathode 19 and the conductive reflector 13 functioning as a reflecting mirror on the anode 12 in order to resonate light emission obtained from the light emitting layer in this embodiment mode. Therefore, a metal having small visible light absorption property and high reflectance is preferably employed as a cathode material. Specifically, Al, Mg, and an alloy thereof are preferably used. The cathode is required to have such thickness that does not transmit visible light since the cathode preferably has reflectance as close to 100 % as possible.

The foregoing organic materials can be applied by either wet or dry process. In the case of high molecular weight materials, spin coating method, ink jetting method, dip coating method, printing method, or the like can be favorably applied. On the other hand, in case of low molecular weight materials, not only dip coating method or spin coating method, but also vacuum vapor deposition can be applied. The anode material and the cathode material may be applied by vapor deposition method, sputtering method, or the like.

The most important thing here is an interval between the cathode 19 and the conductive reflector 13 functioning as a reflecting mirror on the anode 12. In order to amplify light by forming a standing wave, an interval of integral multiple of half wavelength is required. Therefore, the interval between the cathode 19 and the conductive reflector 13 is required to be set so that a film thickness obtained by multiplying a film thickness of an organic material sandwiched between the cathode 19 and the conductive reflector 13 by a refractive index thereof, namely an optical film thickness is of integral multiple of half wavelength of laser light.

In the case of amplifying light of 400 nm, for example, an optical film thickness of at least 200 nm is required, and therefore the interval between the cathode 19 and the conductive reflector 13 is obtained by dividing 200 nm by a refractive index of an organic material. Similarly, in the case of amplifying light of 800 nm, an organic layer requires an optical film thickness of at least 400 nm. Therefore, the interval between the cathode 19 and the conductive reflector 13 is obtained by dividing 400 nm by a refractive index of an organic material. The emission wavelength of the foregoing organic light emitting materials is mainly in a visible light region. Therefore, in order to amplify the visible light defined to be 400 nm to 800 nm, the interval between the conductive reflector 13 and the cathode 19, that is, the optical film thickness of a functional layer is required to be 200 nm or more.

When flowing current between electrodes of an organic laser apparatus shown in FIG. 1, electrons injected from the cathode 19 and holes injected from the anode 12 are recombined mainly in the light emitting layer 16 to emit light. A part of light emission obtained here is amplified between the cathode and the conductive reflector 13 functioning as a reflecting mirror. Accordingly, current flows at a current density higher than a threshold value, so that population inversion is produced and a laser oscillation can be realized. Laser light is extracted from the anode side 12. Laser light can be observed as a relatively sharp emission spectrum of which center is a wavelength that can be amplified within the resonator structure among the spectra radiated from the light emitting layer 16.

example 2

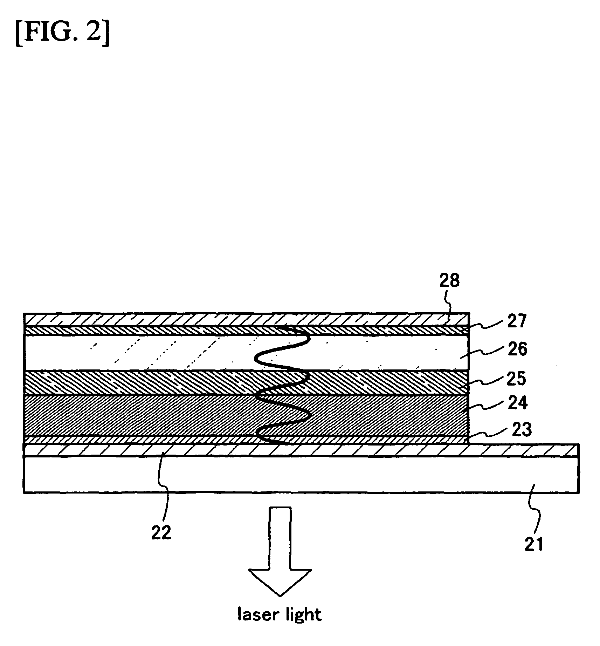

Described in this example is a structure of a laser apparatus in which an anode is utilized as a reflecting mirror. For a substrate 21 in FIG 2, the same material as those described in example 1 can be employed. An anode 22 is formed on the substrate 21. The anode 22 also functions as a reflecting mirror. Accordingly, the anode 22 is made by a material having small visible light absorption property, high reflectance, and conductivity. For the hole injection into an organic compound layer, it is necessary to choose a material with a high work function (a work function of at least 4.0 eV). Ag, Pt, Au, or the like can be used, which satisfy these requirements. The anode 22 functioning as a reflecting mirror has preferably the reflectance of approximately 50 % to 95 % in order to extract laser light therethrough.

The same organic compound layer as the one in Embodiment Mode 1 is formed on the anode 22, that is, a hole injecting layer 23, a hole transporting layer 24, a light emitting layer 25, an electron transporting layer 26, an electron injecting layer 27, and the like are arbitrarily laminated.

Similarly, for a cathode 28, the same material as shown in Embodiment Mode 1 can be employed. An interval between the anode 22 and the cathode 28 (that is, an optical film thickness of the organic compound layer) is required to be manufactured so as to satisfy the requirements described in Embodiment Mode 1. When applying current between electrodes of an organic laser apparatus shown in FIG. 2, electrons injected from the cathode 28 and holes injected from the anode 22 are recombined mainly in the light emitting layer 25 to emit light. A part of light emission obtained here is amplified between the anode 22 and the cathode 28. Accordingly, current flows at a current density higher than a threshold value, so that population inversion is produced and a laser oscillation can be realized. The laser light is extracted from the anode side 22. The laser light is observed as a relatively sharp emission spectrum of which center is a wavelength capable of amplifying within the resonator structure among spectra radiated from the light emitting layer 25.

example 3

Described in examples 1 and 2 are structures in which a resonator structure is formed between an anode or a conductive reflector functioning as a reflecting mirror on the anode and a cathode to occur light amplification and induced radiation due to formation of population inversion produced by current, thus laser oscillation is realized. In these cases, light amplification is performed between electrodes or between the conductive reflector and the cathode, which necessarily increases a film thickness of an organic compound layer. Since that brings an increase in driving voltage directly, voltage for oscillating laser is increased. Described in this example is a structure of a laser apparatus in which a reflecting mirror is provided under a transparent electrode and the transparent electrode is incorporated into a part of a resonator so that the film thickness of an organic compound layer can be reduced.

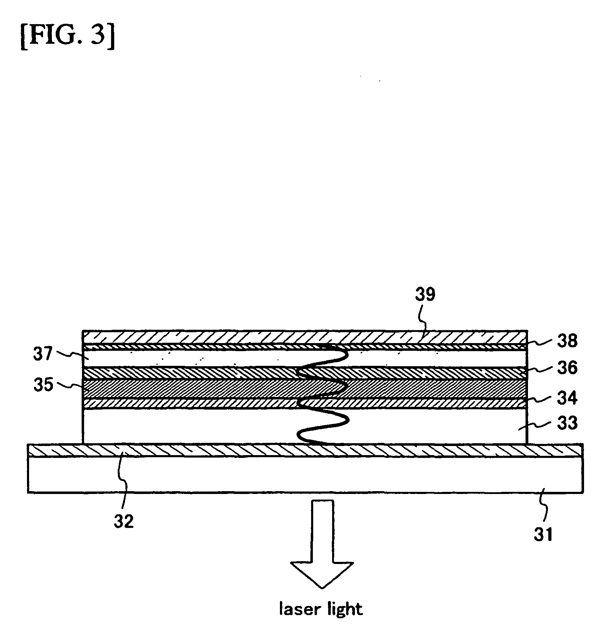

In FIG. 3, laser light is extracted from a substrate side 31, thus it is preferable that the substrate 31 has a high translucency to oscillated laser light. Specifically, the materials described in Embodiment Modes 1 and 2 may be employed.

Reference numeral 32 denotes a reflecting mirror formed on the substrate. Such a material having small visible light absorption property and high reflectance is preferably employed for the reflecting mirror 32. Specifically, metals such as Al, Ag and Pt, or an alloy thereof are suitable. Alternatively, Ti may be formed after an alloy of Al and Si may be formed. A dielectric multilayer film may be employed as well. For example, a dielectric multilayer film obtained by depositing silicon oxide and titanium oxide alternately may be employed. The dielectric multilayer film is formed by a vacuum deposition, sputtering, or the like. In this case, each film thickness of the silicon oxide and the titanium oxide is determined based on wavelength of light to be oscillated and light reflectance can be controlled by the number of layers. In the laser apparatus of this embodiment mode, the reflecting mirror 32 has preferably the reflectance of 50 % to 95 % since light is extracted from the reflecting mirror 32, namely it is an output mirror.

A transparent electrode 33 is formed on the reflecting mirror 32 obtained as described above. For the transparent electrode 33, transparent conductive oxide such as ITO and ZnO, and transparent conductive nitride such as TiN may be employed. Note that, for the hole injection into the organic compound layer, a material with a high work function such as ITO and TiN is preferable. The organic compound layer includes a hole injecting layer 34, a hole transporting layer 35, a light emitting layer 36, an electron transporting layer 37, and an electron injecting layer 38 and the like, that is the same as a laminated structure of an organic EL element which emits light by flowing current thereto. The organic compound layer is formed by employing the method and material described in example 1.

The film thickness of the transparent electrode 33 is determined with consideration as below. It is assumed here that an average refractive index and a film thickness of a functional layer are $n_{org}$ and $d_{org}$, a refractive index and a film thickness of the transparent electrode are $n_{ele}$ and $d_{ele}$ respectively, and a wavelength of light to be oscillated is $\lambda$. An optical film thickness d can be obtained by Formula (1).

**[Formula 1]**

$$d = n_{org} \times d_{org} + n_{ele} \times d_{ele}$$

$$\cdots \ (1)$$

The optical film thickness d is required to be of integral (q) multiple of a half wavelength ($\lambda / 2$) and that satisfies Formula (2).

**[Formula 2]**

$$\frac{\lambda q}{2} = n_{org} \times d_{org} + n_{ele} \times d_{ele}$$

$$\cdots \ (2)$$

Accordingly, the film thickness of the transparent electrode is obtained as Formula (3).

**[Formula 3]**

$$d_{ele} = \frac{(\lambda q/2) - n_{org} \times d_{org}}{n_{ele}}$$

$$\cdots \ (3)$$

In the case where light of 500 nm is to be oscillated, an average refractive index of an organic compound layer is 1.7, a refractive index of a transparent electrode is 2, and a film thickness of the organic compound layer is 100 nm equivalent to that of the standard organic EL element, a film thickness of the transparent electrode is to be 40 nm or 160 nm.

A cathode 39 is formed on an element formed with such a design rule. For the cathode 39, materials described in example 1 can be employed. The cathode 39 functions not as an output mirror but as a reflecting mirror. Therefore, the cathode 39 is only required to be formed so as to have a film thickness that emitted light is not transmitted.

In a structure shown in FIG 3, when applying current between electrodes, electrons injected from the cathode 39 and holes injected from the transparent electrode 33, namely the anode are recombined mainly in the light emitting layer 36 to emit light. A part of the light emission obtained here is amplified between the reflecting mirror 32 and the cathode 39. Accordingly, current flows at a current density higher than a threshold value, so that population inversion is produced and a laser oscillation can be realized. The laser light is extracted from the anode 33 side. The laser light is observed as a relatively sharp emission spectrum of which center is a wavelength which can be amplified within the resonator structure among spectra radiated from the light emitting layer 36.

example 4

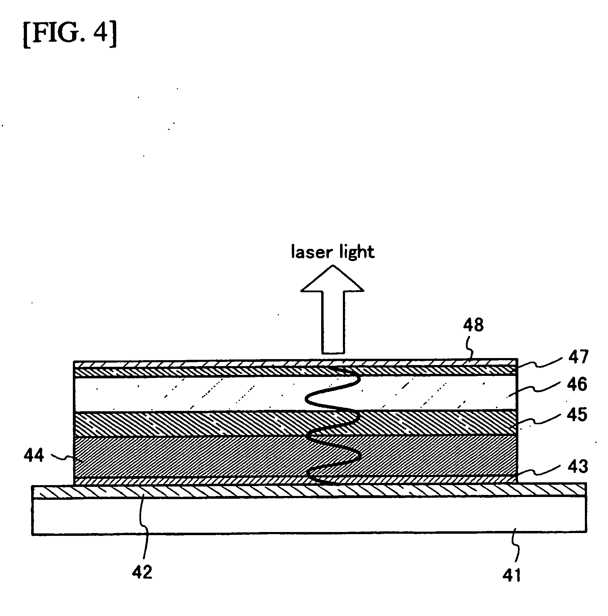

Described in examples 1 to 3 are structures in which laser light is extracted from the substrate side, namely the anode side. In this example, a structure of a laser apparatus in which laser light is extracted from the upper side than the anode relative to a substrate, namely from a cathode side (a top surface of an element) is described. In FIG 4, reference numeral 41 denotes a substrate for which any material can be employed. Not only glass, quartz, plastic, but also a flexible substrate such as paper and cloth can be used. Of course, the substrate is not required to be transparent.

Reference numeral 42 denotes an anode. The anode 42 functions to inject holes into an organic compound layer in addition to as a reflecting mirror. It is necessary to choose a material having small visible light absorption property, high reflectance, and a high work function (a work function of 4.0 eV or more). Ag, Pt, Au, or the like satisfy these requirements. The anode functioning as a reflecting mirror is required to be of such film thickness that visible light is not transmitted. Specifically, the film thickness of several dozens nm to several hundreds nm is preferable.

The same structure as an organic EL element that emits light by flowing current thereto can be employed on the anode 42. That is, a hole injecting layer 43, a hole transporting layer 44, a light emitting layer 45, and an electron transporting layer 46 are formed, for which known materials described in example 1 can be employed. An electron injecting layer 47, which is preferably formed by organic compounds doped with alkali metals such as Li and Ce, is generally formed on the electron transporting layer 46. The electron transporting materials described in example 1 can be used as the organic compound in combination. Subsequently, a cathode 48 is formed, for which the known materials described in example 1 can be employed. Alternatively, an Mg/Ag alloy having an excellent electron injection property can be stacked directly as the cathode 48 instead of forming the electron injecting layer 47. In this structure, laser light is extracted from the top surface, thus the cathode functions as an output mirror. Therefore, the cathode is formed to have transmittance of 50 % to 95 % to the oscillated laser light. For example, in the case of employing a MgAg alloy, the cathode 48 has a film thickness of approximately 5 nm to 20 nm.

By applying current to a laser apparatus of this example formed as described above, light emitted from an organic compound layer is amplified due to induced radiation and then resonated between a cathode and an anode. Consequently, the light can be extracted from a cathode side (a top surface of an element) as laser light.

example 5

Described in this example is a structure of a laser apparatus in which a reflecting mirror is provided under a transparent electrode and the transparent electrode is incorporated into a part of a resonator, so that a film thickness of an organic compound layer can be reduced and laser light can be oscillated from a top surface of a substrate (a side of an electrode which is far apart from the substrate between a pair of electrodes).

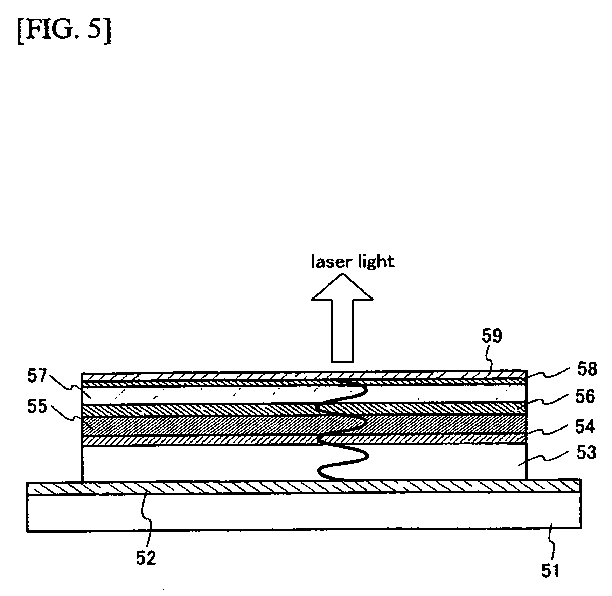

In FIG. 5, reference numeral 51 denotes a substrate for which any material can be employed. Not only glass, quartz, plastic, but also a flexible substrate such as paper and cloth can be used. Of course, the substrate is not required to be transparent. A reflecting mirror 52 is formed on the substrate 51. A material having high reflectance and small visible light absorption property is employed for the reflecting mirror 52. Specifically, a metal such as Al and Ag, an alloy containing these metals as a main component, or a laminated film of a dielectric substance such as $SiO_2$ and $TiO_2$ may be employed. In the laminated film of the dielectric substance, each film thickness is designed so as to selectively reflect light having a wavelength to be oscillated. In addition, the dielectric laminated film is formed by stacking some layers required for total reflection of light. An electrode 53 is formed on the reflecting mirror 52. The electrode 53 is required to inject holes to an organic compound layer and have high transparency. For the electrode 53, a transparent electrode such as ITO and TiN is preferably used.

The similar structure to an organic EL element that emits light by flowing current thereto can be employed on the electrode 53. That is, a hole injecting layer 54, a hole transporting layer 55, a light emitting layer 56, and an electron transporting layer 57 are formed, for which known materials described in example 1 can be employed. Among the hole injecting layer 54 to the electron transporting layer 57, a layer that is not concerned with light emission can be omitted. An electron injecting layer 58, which is preferably formed by an organic compound doped with an alkali metal such as Li and Ce, is generally formed on the electron transporting layer 57. Electron transporting materials described in example 1 can be used as the organic compound in combination. Subsequently, a cathode 59 is formed, for which the known materials described in example 1 can be employed. Alternatively, an MgAg alloy having an excellent electron injection property can be stacked directly as the cathode 59 instead of forming the electron injecting layer 58. In this structure, laser light is extracted from the top surface, thus the cathode 59 functions as an output mirror. Therefore, the cathode is formed to have transmittance of 50 % to 95 % to the oscillated laser light. For example, in the case of employing an Mg/Ag alloy, the cathode 59 has a film thickness of approximately 5 nm to 20 nm.

By applying current to a laser apparatus of this example formed as mentioned above, a part of light amplified due to induced radiation from an organic compound layer is resonated between the cathode 59 and the electrode 53, namely an anode, and then a standing wave is produced. The transparent electrode is incorporated into a resonator, thus a film thickness of the organic compound layer can be reduced. That is, light emission can be realized with low voltage and laser oscillation can be realized with low voltage.

EMBODIMENT MODE

Described in this embodiment mode is a structure of a laser apparatus in which laser light can be extracted from an end surface (an edge part) of a light emitting element, namely a side surface of an organic compound layer.

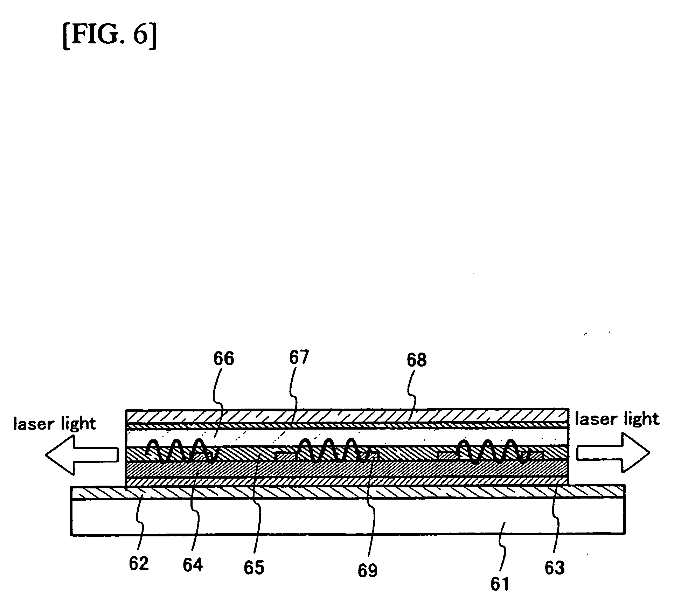

In FIG 6, reference numeral 61 denotes a substrate for which any material can be employed. The materials described in example 5 can be employed. An electrode 62 is formed on the substrate 61. With respect to light amplification due to resonance, only a light emitting component parallel to a film surface is focused here. That is, only a longitudinal resonance mode is focused and a lateral resonance mode as described in examples 1 to 5 is not considered. Therefore, transmittance and reflectance of the electrode is not required to be considered, thus a material for the electrode can be selected in view of a work function as a main parameter. Specifically, a metal having a high work function such as Ag, Pt, and Au, or an alloy thereof may be employed. Though a transparent electrode having a high work function such as ITO and ZnO can be adopted of course, an electrode that is not transparent is preferably adopted in consideration that the light extracted to a direction of the surface may be diffracted.

The same structure as an organic EL element that emits light by flowing current thereto can be employed on the electrode 62. That is, a hole injecting layer 63, a hole transporting layer 64, a light emitting layer 65, an electron transporting layer 66, and an electron injecting layer 67 are formed, for which the methods and materials described in example 1 can be employed. Each film thickness of these organic compound layers and the electrode may be set so as to emit light efficiently. An electrode 68 is formed on the electron injecting layer 67. Transmittance and reflectance of a material can be ignored, thus the material can be selected in view of a work function as a main parameter. Specifically, the materials described in example 1 may be employed.

In this embodiment mode, laser is oscillated from a side surface of the organic compound layer. Therefore, the organic compound layer can be formed to have a narrow width and generally, a width of several $\mu$m and a length of several hundreds $\mu$m are sufficient. The important thing here is control of a plurality of longitudinal modes. In the case where laser light is oscillated in a lateral direction of the organic compound layer, a number of longitudinal modes are generated since a wavelength is generally shorter than the length of the organic compound layer. As a result, a number of longitudinal modes appear in a width of a spectral shape curve. In view of the foregoing, a diffraction grating 69 is formed in the vicinity of the light emitting layer as shown in FIG. 6. For example, the top surface of the hole transporting layer is not formed to be flat but formed in stripes to form the diffraction grating in FIG. 6. Light generated in the light emitting layer is reflected periodically in accordance with the grating interval of the diffraction grating to be resonated and amplified. As a result, very monochromatic light can be amplified. Assuming that a refractive index of the organic compound layer and the oscillation wavelength are represented by n and $\lambda$ respectively, the diffraction grating is preferably formed at a grating interval of ($\lambda$/2n).

Accordingly, single longitudinal mode can be realized to obtain very monochromatic laser light from the side surface of the organic compound layer.

example 6

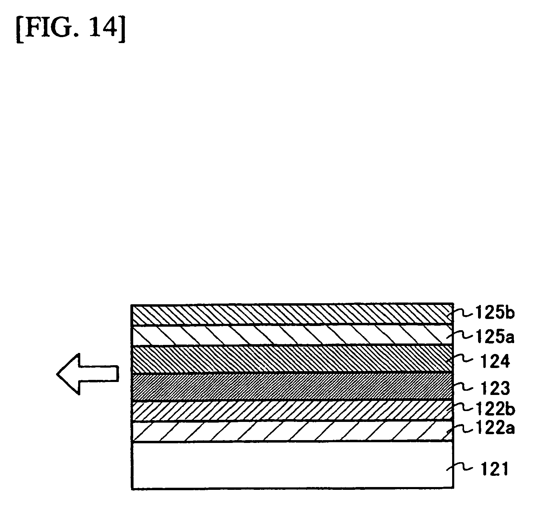

Described in this example is a light emitting element having a structure in which laser light can be extracted from an end surface (an edge part) of the light emitting element with reference to FIG. 14.

In FIG 14, reference numeral 121 denotes a substrate for sustaining an element, for which any material can be employed. Not only glass, quartz, and plastic, but also a flexible substrate such as paper and cloth can be used.

A first electrode 122 is formed on the substrate 121. The first electrode 122 functions as an anode, and in addition, functions as a reflector for reflecting the emitted light. In the light emitting element described in this example, the first electrode 122 comprises two layers (122a and 122b). The first electrode 122a can be formed by any material having high conductivity. The first electrode 122b is in contact with a first layer 123 and functions as a reflector as well as injects holes into the first layer 123. In consideration of injecting holes, the first electrode 122b is preferably formed by a metal oxide having a high work function such as ITO and ZnO, a metal such as Ag, Pt, and Au, an alloy thereof, or the like. In consideration of the function as a reflector, a material having a small visible light absorption property and high reflectance such as Ag is preferably employed. A film thickness thereof is adjusted so as to function as a reflector. As the first electrode 122b is formed by a material having a high work function, a work function of the first electrode 122a is not exclusively limited. The first electrode 122 is not exclusively required to be of two layers and a single layer or a laminated structure of three or more layers may be adopted.

The first layer 123 formed on the first electrode 122b transports holes, and in addition, emits light. In the light emitting element of this example, the first layer 123 is preferably formed by such a material having a higher hole transportation property than an electron transportation property, an excellent hole injection property, and a large energy bandgap. In addition, since the first layer 123 also emits light, a material having a high quantum yield of light emission is preferably employed. For example, aromatic amine can be preferably employed. Specifically, $\alpha$-NPB, TDATA, 4,4'-bis [N-(3-methylphenyl)-N-phenylamino]-biphenyl (described as TPD, hereinafter), 4,4'-4"-tris (N-carbazolyl) triphenylamine (described as TCTA, hereinafter) or the like can be employed. Alternatively, a high molecular weight material such as poly (vinyl carbazole) which has an excellent hole transportation property may be employed. Note that, it is particularly desirable to employ triphenylamine derivative. The first layer 123 is not limited to a single layer and may be a laminated structure of two or more layers formed by the above-described materials.

A second layer 124 is formed on the first layer 123. The second layer transports electrons. The second layer 124 is preferably formed by such a material having a higher electron transportation property than a hole transportation property, an excellent electron injection property, and large ionization potential. For example, a metal complex having a quinoline skeleton or a benzoquinoline skeleton typified by $Alq_3$, a mixed ligand complex thereof, or the like are preferably employed. Alternatively, other than the metal complexes, an oxadiazole derivative such as PBD and OXD-7, a triazole derivative such as TAZ and p-EtTAZ, a phenanthroline derivative such as Bphen and BCP, and 4,4'-(N-carbazolyl) biphenyl (described as CBP, hereinafter) can be employed. A substance for the second substrate 124 preferably has larger bandgap and ionization potential than a substance for the first substrate 123. Spectfically, a phenanthroline derivative such as CBP and BCP, and a carbazole derivative can be employed. Note that, the second layer 124 is not limited to a single layer and may be a laminated structure of two or more layers formed by the above-described material.

A second electrode 125 is formed on the second layer 124. The second electrode 125 functions as a cathode, and in addition, functions as a reflector for reflecting the emitted light. In the light emitting element described in this embodiment mode, the second electrode 125 comprises two layers (125a and 125b). The second electrode 125a is in contact with the second layer 124 and injects electrons into the second layer 124. Therefore, the second electrode 125a preferably is formed by a material having a low work function such as a representative element of group 1 or 2 in the periodic table, that is, an alkali metal such as Li and Cs; an alkali earth metal such as Mg, Ca, and Sr; an alloy containing the foregoing materials (Mg/Ag and Al/Li); or a transition metal containing a rare earth metal. The second electrode 125b functions as a reflector. Accordingly, a metal having a small visible light absorption property and high reflectance such as Ag, Al, Mg, or an alloy thereof is preferably employed. A film thickness thereof is adjusted so as to function as a reflector. As the second electrode 125a is formed by a material having a low work function, a work function of the second electrode 125b is not exclusively limited. The second electrode 125 is not exclusively required to be of two layers and a single layer or a laminated structure of three or more layers may be adopted.

The first layer 123 and the second layer 124 can be formed by either wet or dry process. In the case of a high molecular weight material, spin coating method, ink jetting method, dip coating method, printing method, or the like can be appropriately applied. On the other hand, in the case of a low molecular weight material, not only dip coating method and spin coating method, but also vapor deposition can be applied. The first electrode 122 and the second electrode 125 can be formed by any process and formed by vapor deposition method, sputtering method, or the like.

The first layer 123 and the second layer 124 are sandwiched between the first electrode 122 and the second electrode 125 each functioning as a reflector. The light emitted in these two sandwiched layers is resonated and amplified. Therefore, the total optical film thickness of these two layers is required to be of integral multiple of half wavelength of the emitted light. That is, an interval between the first electrode 122 and the second electrode 125 is obtained by dividing an optical film thickness of the first layer 123 and the second layer 124 by a refractive index.

In this example, two layers that are the first layer 123 and the second layer 124 are formed between the first electrode 122 and the second electrode 125, however, the invention is not limited to this and a structure of three or more layers including another functional layer may be adopted. For example, functions such as an electron injecting layer, a hole injecting layer, and a hole blocking layer may be provided.

In the above-described light emitting element, a threshold value of induced radiation is at a current density of 200 $mA/cm^2$ or less in a variation of emission intensity with respect to current density. Therefore, population inversion is produced in the case of flowing current so as to have current density larger than the threshold value. It is preferable that the threshold value is in the range of 2 $mA/cm^2$ to 50 $mA/cm^2$ in consideration of the durability of the light emitting element. Electrons and holes injected from respective electrodes are recombined in the population inversion region. Then a part of emitted light is resonated and amplified between reflectors (the first electrode and the second electrode in this embodiment mode). The emission spectra of the emitted light show a relatively sharp peak, of which center is a light emission wavelength which can be resonated within the light emitting element. The above-described light emitting element can be employed, for example, as a laser oscillator, that is a laser apparatus.

example 1

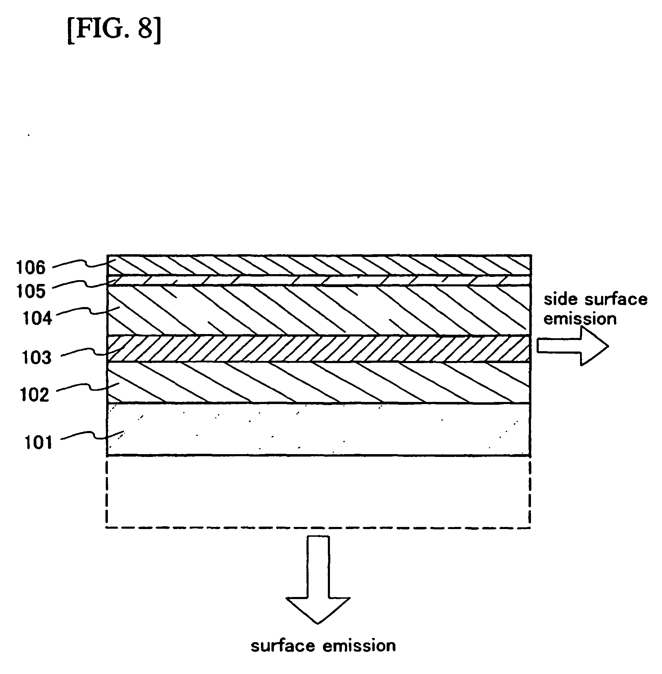

Described hereinafter is an example. FIG 8 shows an element structure of a sample formed in this example. A glass substrate (for example, #1737 glass produced by Coming Corp) is adopted as a substrate for forming a cover film such as an electrode and a light emitting layer. An ITO film is formed thereon as an anode 101 in a film thickness of 100 nm by sputtering method.

On the anode 101, a hole transporting layer 102 is formed in a film thickness of 135 nm by vapor deposition of α-NPB that is a hole transport material. Subsequently, on the hole transporting layer 102, a light emitting layer 103 is formed in a film thickness of 30 nm by co-deposition of 4,4'-N,N'-di carbazolyl-biphenyl (described as a CBP, hereinafter) that is a host material and an iridium complex $Ir(tpy)_2(acac)$ that is a triplet light emitting material. The weight ratio of the CBP and the iridium complex is 10 : 1. On these films, BCP for a blocking and electron transporting layer 104, calcium fluoride ($CaF_2$) that is an electron injection material for an electron injecting layer 105, and Al for a cathode 106 are formed by deposition to be a sandwich structure. Note that, the size of the element can be determined arbitrarily, which is 2 mm x 2 mm in this example.

Each film thickness of layers formed by organic materials is set so as to amplify emitted light within an organic compound layer. That is, each film thickness is preferably set so as to produce a standing wave while repeating reflection of the light emitted from the Ir complex added in the CBP layer and from the 4,4'-bis [N-(1-naphthyl)-N-phenyl-amino]-biphenyl (described as α-NPB, hereinafter) layer at the interface between the ITO and the organic compound layer, the interface between the BCP layer and the $CaF_2$ layer, or the interface between the $CaF_2$ layer and the Al layer.

Materials capable of emitting light are the Ir complex and the α-NPB among the organic materials employed in this example. These materials give light emission in a visible light region (400 nm to 800 nm). In order to produce a standing wave, it is necessary that the interval between reflective surfaces is of integral multiple of a value obtained by dividing a half wavelength of a standing wave by a refractive index of the organic material. For example, in order to produce a standing wave of light at 400 nm, the interval between the reflective surfaces is required to be of integral multiple of a value obtained by dividing 200 nm by a refractive index of the organic material. Assuming that a refractive index of the organic material is 1.7, the interval between the reflective surfaces is of integral multiple of value obtained by dividing 200 by 1.7, namely 120 nm. That is, the total film thickness of the α-NPB layer, the CBP layer, and the BCP layer is required to be of integral multiple of 120 nm. Similarly, in order to produce a standing wave of light at 800 nm, the total optical film thickness of the α-NPB, the CBP layer, and the BCP layer is required to be of integral multiple of 400 nm, such as 400 nm, 800 nm, and 1200 nm. Assuming that a refractive index is 1.7, the total film thickness is required to be of integral multiple of 240 nm, such as 240 nm, 480 nm, and 720 nm. The interval between reflective surfaces, that is the total film thickness of the α-NPB, the CBP layer, and the BCP layer is of integral multiple of 240 nm, such as 240 nm, 480 nm, and 720 nm.

In this example, in view of the foregoing, an organic EL element described in FIG. 8 has an organic compound layer in a film thickness of 270 nm so as to have a thick film thickness for an organic EL element consciously. However, a film thickness of the organic EL element is not limited to this. In the case of the organic EL element described in FIG. 8, assuming that a refractive index of an organic compound is 1.7, light having a wavelength obtained by dividing 920 nm by integral number can produce a standing wave and that wavelength is 460 nm in the visible light region.

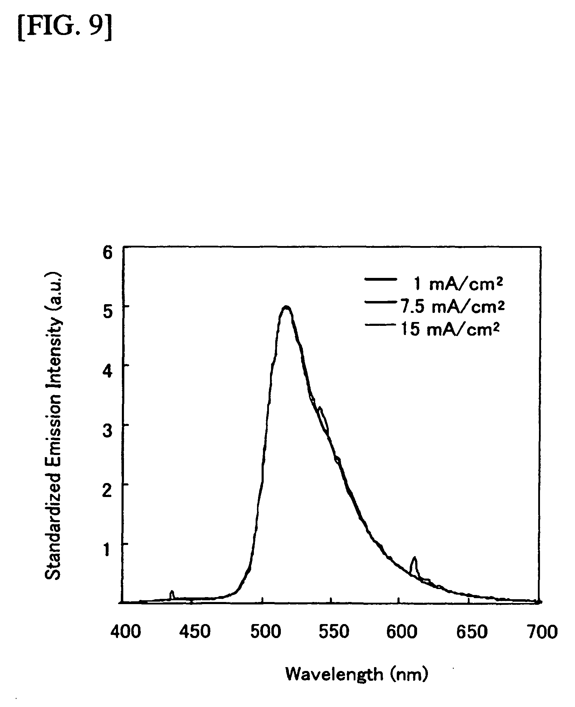

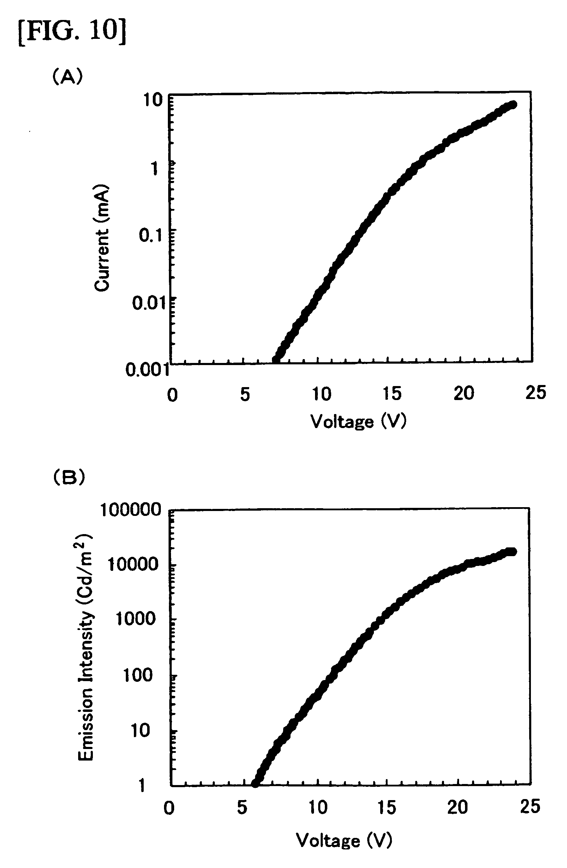

FIG 9 shows emission spectra obtained by measuring the organic EL element shown in FIG. 8 from the substrate side. Light emission is obtained by applying DC voltage to flow current so that ITO serves as an anode and Al serves as a cathode. FIG 10(A) shows voltage-current density characteristic, indicating that current of several mA flows by applying approximately 20 V. A light emitting area of the element is 0.04 $cm^2$, therefore, current density results in approximately 100 $mA/cm^2$. FIG 10(B) shows voltage-emission intensity characteristic. The emission intensity is measured from the side for extracting light emission (ITO side). Light emission starts at approximately 6 V, light emission of several tens of thousands candela (Cd) is obtained by applying 24 V.

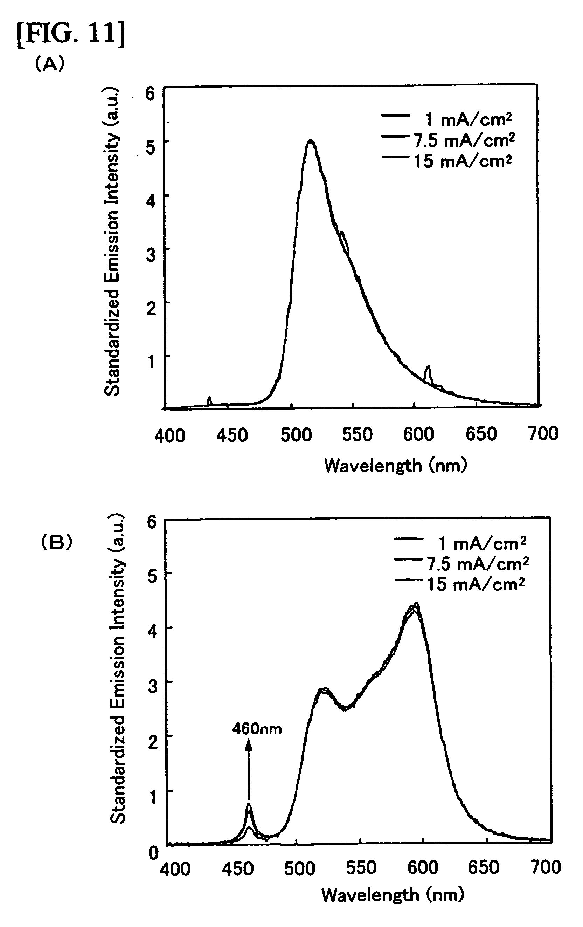

FIGS. 11(A) and (B) show emission spectra of the organic EL element shown in FIG 8. Each spectrum is standardized at the highest emission intensity. FIG 11(A) shows surface emission spectra measured from the ITO side. FIG 11(B) shows side surface emission spectra measured from the side of the element.

In FIG 11(A), a strong light emission is measured in the wavelength range of 475 nm to 650 nm. This light emission is based on a light emission from an Ir complex. In the vicinity of 400 nm to 475 nm, another light emission is measured. This light emission is based on a light emission from an α-NPB layer. Accordingly, it can be considered that carriers (holes and electrons) are recombined mainly in the CBP layer to contribute to the light emission from the Ir, whereas a part of the carriers is recombined in the α-NPB layer. In this surface emission, emission intensity is varied in proportion to the variation in current density. Therefore, spectra take an identical shape at any current density and only intensity increases linearly in proportion to the increase in current density.

Compared to the spectra shown in FIG 11(A), emission spectra obtained from the side surface of the element have two characteristics as shown in FIG 11(B). Firstly, a waveform of emission spectra in the wavelength range of 475 nm to 650 nm is different. Secondly, sharp emission spectra are measured in the vicinity of 460 nm. The cause of the former is not clear, whereas the cause of the emission spectra of the latter is considered that a standing wave is produced in an organic compound layer of an element and only light having this wavelength is amplified. As mentioned above, a wavelength capable of producing a standing wave in a film thickness of this element is practically 460 nm. The most outstanding characteristic is that light emission in the wavelength range of 475 nm to 650 nm varies in intensity in proportion to the increase in current density, whereas other emission spectra each having a peak in the vicinity of 460 nm increase in emission intensity more largely than the increase in current density. Therefore, only a light emission of 460 nm is relatively increased in FIG 11 (B) in which emission intensity is standardized.

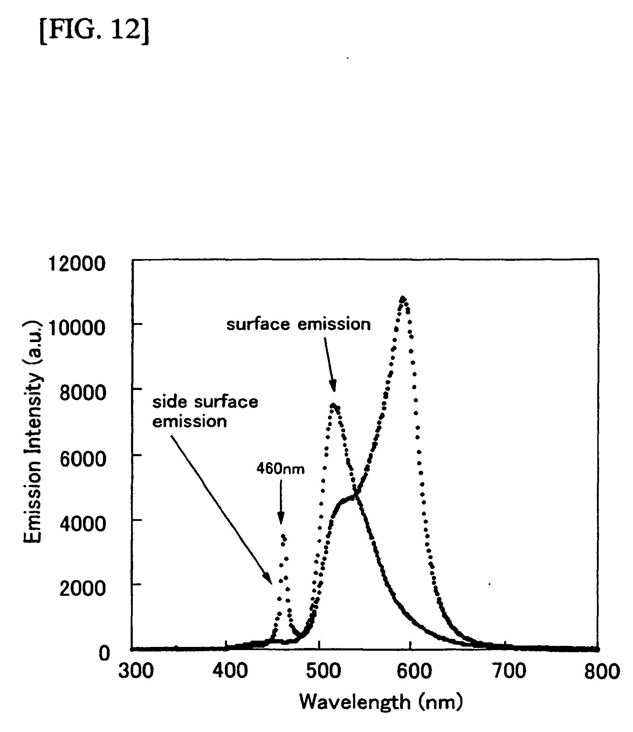

As a result of the foregoing, it is considered that light having a wavelength of 460 nm produces a standing wave in the organic EL element shown in FIG 8. In other words, this element functions as a resonator of light of 460 nm to amplify the light. As the current density is further increased to 120 mA/cm$^2$, a shape of the surface emission spectra is not varied at all, while emission intensity of 460 nm is further increased to give a sharp emission signal (FIG. 12).

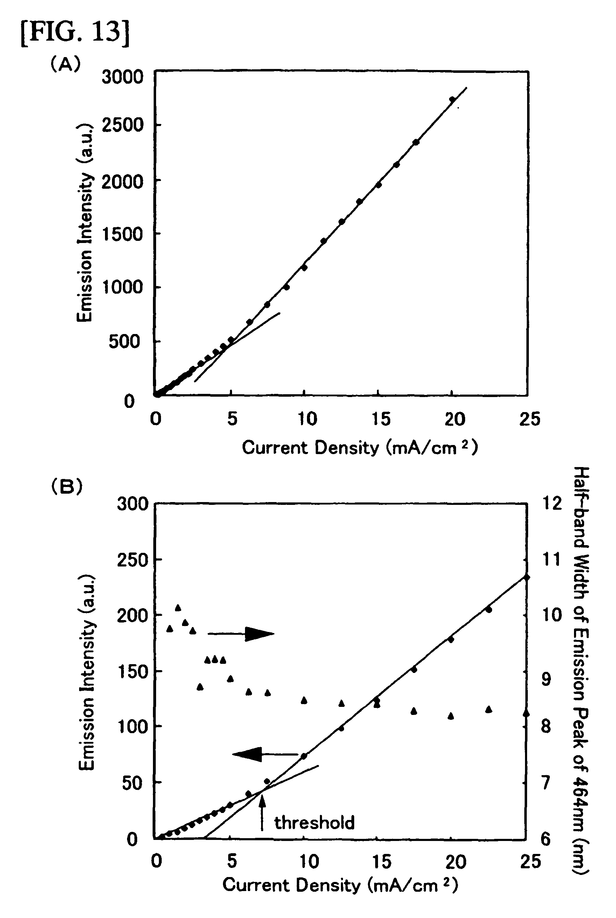

FIG 13 shows graphs, in which emission intensity of light having a wavelength of 460 nm is plotted against current density. FIG 13(A) shows a measurement result of light emitted from the surface side of the organic EL element shown in FIG 8. FIG 13(B) shows a measurement result of light emitted from the side surface of the element. In each characteristic, emission intensity linearly increases according to the increase in current density. However, the increase is not monotonous. In each light emission, it is indicated that there is a threshold value to vary the slope at a current density in the vicinity of 5 mA/cm$^2$ to 10 mA/cm$^2$. At this time, it can be considered that light emission is due to spontaneous emission at a current density lower than the threshold value, while light emission is due to stimulated emission at a current density higher than the threshold value.

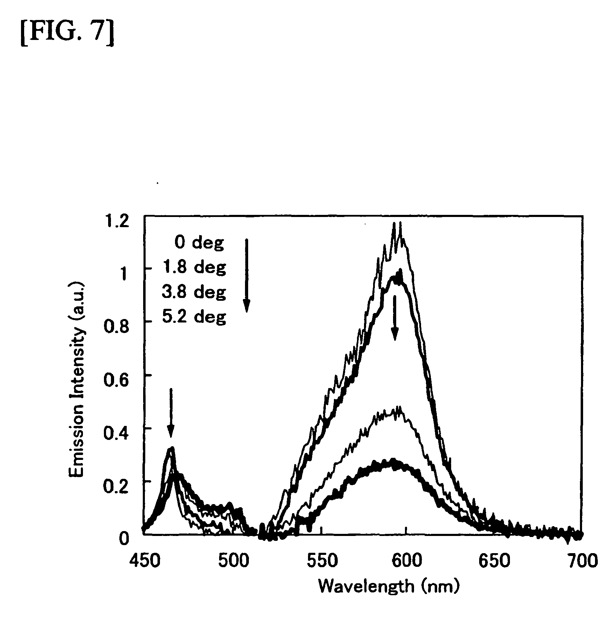

FIG. 13(B) also shows a half-band width of an emission spectrum having an emission peak of 460 nm plotted against current density. The half-band width is decreased drastically until a current density reaches the threshold value. After the current density reaches the threshold value, the half-band width is decreased gradually. FIG 7 shows a measurement result of measuring angle dependence of emission spectra from the side surface of the element, which is obtained by subtracting an emission spectrum observed from the front surface from an emission spectrum at respective angles. As shown in the figure, light emission from the side surface of the element is measured at various angles in the range of 0 degree to 61 degrees, however, there is no dramatic change in an emission wavelength and a half-band width. Accordingly, it can be considered that the decrease in a half-band width is not because refractive index is dependent on a wavelength. In other words, the reason the emission spectrum seems sharp in appearance is not because only a portion of a wavelength of light emission is selectively focused to observe.

On the other hand, in each case of surface emission and side surface emission, light emission of 475 nm to 650 nm does not have a threshold value. Light emission in this wavelength range linearly increases its intensity according to the increase in current density and an increase rate of the light emission tends to be decreased in a high current region. This is similar to the typical behavior of a general organic EL element. In addition, since light emission of 460 nm observed from the ITO side of the element gives a broad spectrum at any current density, the half-band width thereof cannot be obtained.

Table 1 shows laser oscillation characteristics of a sample (element) which is formed in this example. A measurement result of three identical samples is shown, showing a peak wavelength in the range of 462 nm to 464 nm, a half-band width of 10 nm or less, and a threshold value in the range of 10 mA/cm$^2$ to 12.5 mA/cm$^2$ respectively. These characteristics are measured at room temperature.

(Table 1)

Laser Oscillation Behavior of the Manufactured Element

| Sample No. | Threshold Value (mA/cm$^2$) | Peak Wavelength (nm) | Half-band Width[1] (nm) |
|---|---|---|---|
| 1 | 12.5 | 464 | 8.0 |
| 2 | 10.0 | 462 | 8.0[2] |
| 3 | 11.0 | 463 | 9.1 |

[1] half-band width at 50 mA/cm$^2$
[2] half-band width at 60 mA/cm$^2$

The above-described result can lead to the following conclusion. The element of this example has a resonator structure for light emission around 460 nm to form a standing wave of light having this wavelength. In addition, light emission of 460 nm has a threshold value at a current density. These behaviors are similar to that of a so-called solid-state laser. In the case that the threshold value indicates that so-called population inversion is started, laser light is oscillated at a current density larger than that of the threshold value.

example 2

Described hereinafter is a light emitting element of the invention and characteristics thereof.

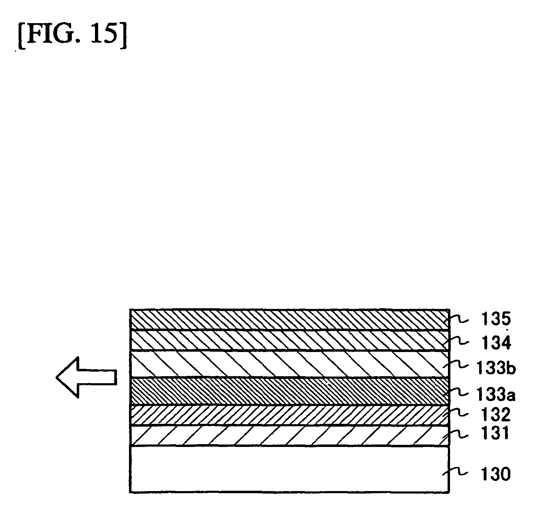

A structure of a light emitting element described in this example is illustrated with reference to FIG 15. An electrode 131 is formed on a glass substrate 130 by using ITO. A first layer 132 is formed on the electrode 131 by vacuum vapor deposition of α-NPB, and a second layer 133 (133a and 133b) is formed thereon by using CBP and BCP sequentially. A third layer 134 is formed on the second layer 133 by using calcium fluoride, and an electrode 135 is formed thereon by using aluminum, so that a light emitting element is completed. Each film thickness of the first layer 132, the second layers 133a and 133b is 100 nm, 30 nm and 130 nm, and the total film thickness thereof is 260 nm. In the above-described light emitting element, the electrode 131 and the third layer 134 function as a reflector respectively. In this manner, the light emitting element of this example is structured so as to resonate the emitted light.

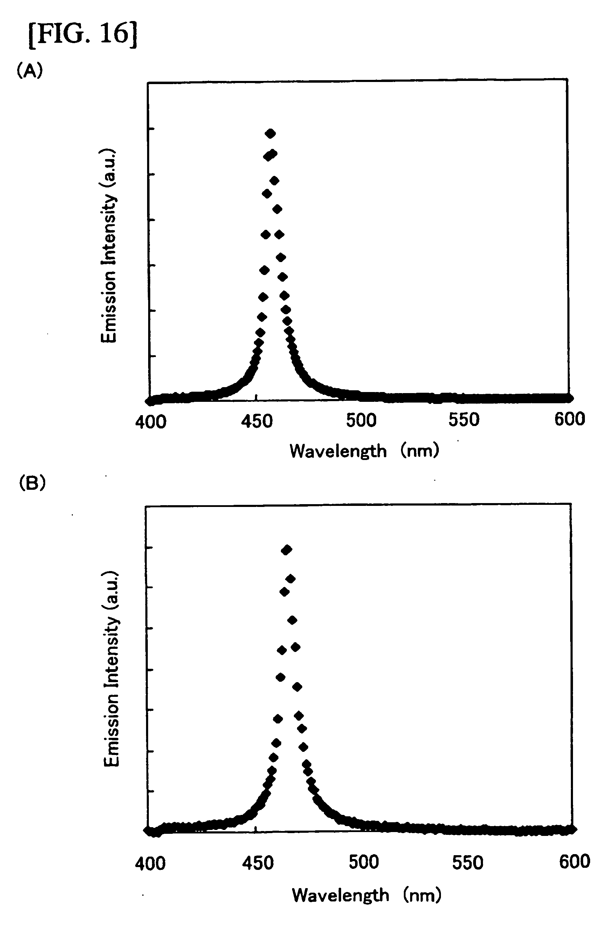

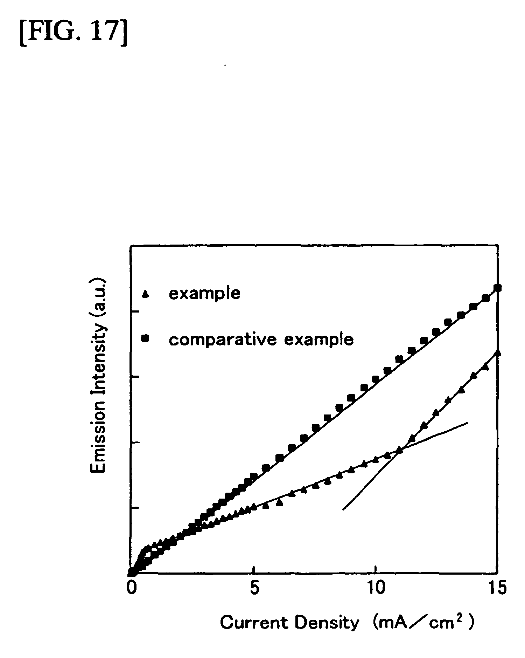

FIG 16(A) shows an emission spectrum of the light emitting element having the structure shown in FIG. 15. FIG 16(A) indicates that light emission having a peak at a wavelength of 465 nm with a narrow half-band width is obtained. Change in emission intensity with respect to current density is shown in FIG 17. FIG 17 indicates that emission intensity linearly increases according to the increase in current density and a slope thereof becomes shaper after at a bend point (namely, a threshold value) of a current density of 12 mA/cm$^2$. Accordingly, it can be considered that light emission is due to spontaneous emission at a current density lower than 12 mA/cm$^2$ while light emission is due to stimulated emission at a current density higher than 12 mA/cm$^2$.

(Comparative Example)

A comparative example of a light emitting element having the structure shown in FIG 15 is described.

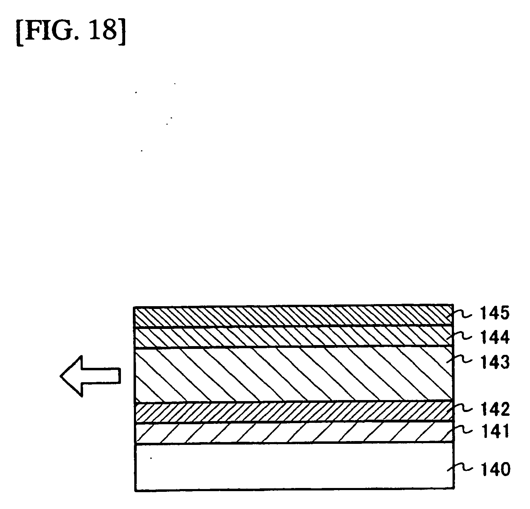

An electrode 141 is formed on a glass substrate 140 by using ITO as shown in FIG 18. A first layer 142 is formed on the electrode 141 by vacuum vapor deposition of $\alpha$-NPB, and a second layer 143 is formed on the first layer 142 by using BCP. A third layer 144 is formed on the second layer 143 by using calcium fluoride, and an electrode 145 is formed thereon by using aluminum, so that a light emitting element is completed. Each film thickness of the first layer 142 and the second layer 143 is 100 nm and 160 nm, and the total film thickness thereof is 260 nm. In the above-described light emitting element, the electrode 141 and the third layer 144 function as a reflector respectively. In this manner, the light emitting element of the comparative example is structured so as to resonate emitted light.

FIG. 16(B) shows an emission spectrum of a light emitting element having the structure shown in FIG 18. FIG 16(B) indicates that light emission having a peak at a wavelength of 460 nm with a narrow half-band width is obtained. As for a dependence of emission intensity on current density (FIG 17), the emission intensity linearly increases according to an increase in the current density but there is no bend point unlike the light emitting element having the structure shown in FIG 15.

## Claims

1. An edge emitting, electrically pumped organic laser apparatus comprising: first and second electrodes (62, 68); and an organic compound layer interposed between the first electrode (62) and the second electrode (68), the organic compound layer comprising:

   a hole injection layer (63) adjacent to the first electrode;
   a hole transporting layer (64) adjacent to the hole injection layer (63);
   an emission layer (65) adjacent to the hole transporting layer (64) wherein the hole transporting layer (64) is interposed between the hole injection layer (63) and the emission layer (65);
   an electron transporting layer (66) adjacent to the emission layer (65); and
   an electron injecting layer (67) adjacent to the electron transporting layer (66) wherein the electron transporting layer (66) is interposed between the electron injecting layer (67) and the emission layer (65),
   wherein stripes are formed in the hole transporting layer (64) to form a diffraction grating (69) and wherein a top surface of the stripe form is overlapped by the emission layer (65),
   wherein the first electrode (62) is not transparent and the second electrode (68) comprises a metal having a thickness so as not to transmit visible light,
   wherein the emission layer (65) radiates light having a peak with a half-band width of 10 nm or less.

2. The organic laser apparatus according to claim 1 wherein the light emitting layer (65) contains a metal complex as a dopant.

3. The organic laser apparatus according to claim 1 or 2 wherein a host material of the light emitting layer (65) is 4,4'-N,N'-di carbazolyl-biphenyl and a material for the hole transporting layer (64) is 4,4'-bis [N-(1-naphthyl)-N-phenyl-amino]-biphenyl.

4. The organic laser apparatus according to claim 1, 2 or 3 wherein light having the emission peak is radiated from a direction which intersects a direction for injecting the current.

**5.** The organic laser apparatus according to any one of the claims 1 - 4 wherein the half-band width of an emission peak is varied by 20 % or more until a current density for injecting current into the organic compound layer reaches the threshold value.

**6.** The organic laser apparatus according to any one of claims 1 - 5, wherein the hole injection layer (63) comprises a metal oxide.

**7.** The organic laser apparatus according to any one of the claims 1 - 6, wherein the organic compound layer comprises a phosphorescent compound.

**8.** The organic laser apparatus according to any one of claims 1 to 7, further comprising at least one reflection layer formed between the organic compound layer and at least one of the first and second electrodes (62, 68).

**9.** The organic laser apparatus according to any one of claims 1 - 8, wherein the metal oxide is at least one material oxide selected from the group consisting of vanadium oxide, molybdenum oxide, ruthenium oxide, and aluminium oxide.

**10.** The organic laser apparatus according to any one of the claims 1 - 9, wherein the organic compound layer is arranged to allow recombination of holes and electrons mainly in the emission layer.

**Patentansprüche**

**1.** Randemittierendes, elektrisch gepumptes organisches Laserbauelement, das umfasst:

eine erste Elektrode und eine zweite Elektrode (62, 68); und
eine organische Verbundungsschicht zwischen der ersten Elektrode (62) und der zweiten Elektrode (68), wobei die organische Verbundungsschicht umfasst:

eine Elektronenfehlstelleninjektionsschicht (63) neben der ersten Elektrode;
eine Elektronenfehlstellentransportschicht (64) neben der Elektronenfehlstelleninjektionsschicht (63);
eine emittierende Schicht (65) neben der Elektronenfehlstellentransportschicht (64), wobei die Elektronenfehlstellentransportschicht (64) zwischen der Elektronenfehlstelleninjektionsschicht (63) und der emittierenden Schicht (65) angeordnet ist;
eine Elektronentransportschicht (66) neben der emittierenden Schicht (65); und
eine Elektroneninjektionsschicht (67) neben der Elektronentransportschicht (66), wobei die Elektronentransportschicht (66) zwischen der Elektroneninjektionsschicht (67) und der emittierenden Schicht (65) angeordnet ist,
wobei Streifen in der Elektronenfehlstellentransportschicht (64) ausgebildet sind, um ein Beugungsgitter (69) auszubilden, und wobei eine oberste Oberfläche der Streifenform von der emittierenden Schicht (65) überlappt wird,
wobei die erste Elektrode (62) nicht durchsichtig ist und die zweite Elektrode (68) ein Metall umfasst, das eine Dicke hat, um nicht sichtbares Licht durchzulassen,
wobei die emittierende Schicht (65) Licht strahlt, das einen Höhepunkt mit einer Halbwertsbreite von 10 nm oder weniger hat.

**2.** Organisches Laserbauelement nach Anspruch 1, wobei die lichtemittierende Schicht (65) als Dotiermittel einen Metallkomplex enthält.

**3.** Organisches Laserbauelement nach Anspruch 1 oder 2, wobei ein Wirtmaterial der lichtemittierenden Schicht (65) 4,4'-N,N'-Di Carbazolyl-Biphenyl ist und ein Material für die Elektronenfehlstellentransportschicht (64) 4,4'-Bis[N-(1-Naphthyl)-N-Phenyl-Amino]Biphenyl ist.

**4.** Organisches Laserbauelement nach Anspruch 1, 2, oder 3, wobei Licht mit dem Emissionshöhepunkt aus einer Richtung gestrahlt wird, die eine Injektionsrichtung des Stroms kreuzt.

**5.** Organisches Laserbauelement nach einem der Ansprüche 1-4, wobei die Halbwertsbreite eines Emissionspeaks um 20 % oder mehr geändert wird, bis eine Stromdichte zur Injektion des Stroms in die organische Verbindungsschicht den Schwellenwert erreicht.

**6.** Organisches Laserbauelement nach einem der Ansprüche 1-5, wobei die Elektronenfehlstelleninjektionsschicht (63) ein Metalloxid umfasst.

**7.** Organisches Laserbauelement nach einem der Ansprüche 1-6, wobei die organische Verbindungsschicht eine phosphoreszierende Verbindung umfasst.

**8.** Organisches Laserbauelement nach einem der Ansprüche 1-7, das ferner umfasst:

zumindest eine Reflexionsschicht zwischen der organischen Verbindungsschicht und zumidest der ersten Elektrode oder der zweiten Elektrode (62, 68).

**9.** Organisches Laserbauelement nach einem der Ansprüche 1-8, wobei das Metalloxid zumindest ein Materialoxid ist, das aus der Gruppe ausgewählt wird, die aus Vanadiumoxid, Molybdänoxid, Rutheniumoxid, und Aluminiumoxid besteht.

**10.** Organisches Laserbauelement nach einem der Ansprüche 1-9, wobei die organische Verbindungsschicht angeordnet ist, um Rekombination von Elektronenfehlstellen und Elektronen hauptsächlich in der emittierenden Schicht zu erlauben.

## Revendications

**1.** Appareil laser organique à émission latérale et à pompage électrique, comprenant : une première et une seconde électrode (62, 68) ;
et une couche de composé organique intercalée entre la première électrode (62) et la seconde électrode (68), la couche de composé organique comprenant :

une couche d'injection de trous (63) adjacente à la première électrode ;
une couche de transport de trous (64) adjacente à la couche d'injection de trous (63) ;
une couche d'émission (65) adjacente à la couche de transport de trous (64), la couche de transport de trous (64) étant intercalée entre la couche d'injection de trous (63) et la couche d'émission (65) ;
une couche de transport d'électrons (66) adjacente à la couche d'émission (65) ; et
une couche d'injection d'électrons (67) adjacente à la couche de transport d'électrons (66), la couche de transport d'électrons (66) étant intercalée entre la couche d'injection d'électrons (67) et la couche d'émission (65),
dans lequel des bandes sont formées dans la couche de transport de trous (64) pour former un réseau de diffraction (69) et dans lequel une surface supérieure de la forme en bande est recouverte par la couche d'émission (65),
dans lequel la première électrode (62) n'est pas transparente et la seconde électrode (68) comprend un métal ayant une épaisseur telle que la lumière visible n'est pas transmise,
dans lequel la couche d'émission (65) émet une lumière présentant un pic avec une demi-largeur de bande de 10 nm ou moins.

**2.** Appareil laser organique selon la revendication 1 dans lequel la couche électroluminescente (65) contient un complexe métallique en tant que dopant.

**3.** Appareil laser organique selon la revendication 1 ou 2 dans lequel un matériau hôte de la couche électroluminescente (65) est le 4,4'-N,N'-dicarbazolyl-biphényle et un matériau pour la couche de transport de trous (64) est le 4,4'-bis [N-(1-naphtyl)-N-phénylamino]biphényle.

**4.** Appareil laser organique selon la revendication 1, 2 ou 3 dans lequel la lumière présentant le pic d'émission est émise dans une direction qui croise une direction pour l'injection du courant.

**5.** Appareil laser organique selon l'une quelconque des revendications 1-4 dans lequel on fait varier de 20 % ou plus la demi-largeur de bande d'un pic d'émission jusqu'à ce qu'une densité de courant permettant l'injection de courant dans la couche de composé organique atteigne la valeur-seuil.

6. Appareil laser organique selon l'une quelconque des revendications 1-5, dans lequel la couche d'injection de trous (63) comprend un oxyde métallique.

7. Appareil laser organique selon l'une quelconque des revendications 1-6, dans lequel la couche de composé organique comprend un composé phosphorescent.

8. Appareil laser organique selon l'une quelconque des revendications 1-7, comprenant en outre au moins une couche de réflexion formée entre la couche de composé organique et au moins une desdites première et seconde électrodes (62, 68).

9. Appareil laser organique selon l'une quelconque des revendications 1-8, dans lequel l'oxyde métallique est au moins un matériau oxyde choisi dans le groupe constitué d'un oxyde de vanadium, d'un oxyde de molybdène, d'un oxyde de ruthénium, et d'un oxyde d'aluminium.

10. Appareil laser organique selon l'une quelconque des revendications 1-9, dans lequel la couche de composé organique est conçue pour permettre la recombinaison de trous et d'électrons essentiellement dans la couche d'émission.

[FIG. 1]

19

18

17

16

15

14

13  12

11

laser light

[FIG. 2]

28

27

26

25

24

23

22

21

laser light

[FIG. 3]

laser light

[FIG. 4]

laser light

48
47
46
45
44
43
42
41

[FIG. 5]

[FIG. 6]

[FIG. 7]

[FIG. 8]

106
105
104
103
102
101

side surface
emission

surface emission

[FIG. 9]

[FIG. 10]

(A)

(B)

[FIG. 11]

(A)

(B)

[FIG. 12]

[FIG. 13]

(A)

(B)

[FIG. 14]

125b
125a
124
123
122b
122a
121

[FIG. 15]

[FIG. 16]

(A)

(B)

[FIG. 17]

[FIG. 18]

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- WO 0036664 A
- EP 1154676 A
- EP 0878883 A

### Non-patent literature cited in the description

- **Nir Tessler.** Lasers Based on Semiconducting Organic Materials. *Adv. Mater.,* 1999, vol. 11, 363-370